(19) Europäisches Patentamt
European Patent Office
Office européen des brevets

(11) Publication number: **0 323 342 B1**

(12) **EUROPEAN PATENT SPECIFICATION**

(45) Date of publication of patent specification: **08.06.94**   (51) Int. Cl.5: **H01L 39/12**, H01L 39/24

(21) Application number: **88403324.2**

(22) Date of filing: **26.12.88**

(54) **A semiconductor substrate having a superconducting thin film.**

(30) Priority: **25.12.87 JP 328471/87**
**25.12.87 JP 328472/87**
**25.12.87 JP 328473/87**
**25.12.87 JP 328474/87**
**25.12.87 JP 328475/87**
**25.12.87 JP 328476/87**
**25.12.87 JP 328477/87**
**25.12.87 JP 328478/87**
**25.12.87 JP 328479/87**
**25.12.87 JP 328480/87**
**25.12.87 JP 328481/87**
**25.12.87 JP 328482/87**

(43) Date of publication of application:
**05.07.89 Bulletin 89/27**

(45) Publication of the grant of the patent:
**08.06.94 Bulletin 94/23**

(84) Designated Contracting States:
**DE FR GB NL**

(56) References cited:
**EP-A- 0 282 012**

(73) Proprietor: **SUMITOMO ELECTRIC INDUSTRIES LIMITED**
**No. 15, Kitahama 5-chome,**
**Higashi-ku**
**Osaka-shi, Osaka 541(JP)**

(72) Inventor: **Itozaki, Hideo Itami Works of Sumitomo**
**Electric Industries Ltd.**
**1-1, Koyakita 1-chome**
**Itami-shi Hyogo(JP)**
Inventor: **Harada, Keizo Itami Works of Sumitomo**
**Electric Industries Ltd.**
**1-1, Koyakita 1-chome**
**Itami-shi Hyogo(JP)**
Inventor: **Fujimori, Naoji Itami Works of Sumitomo**
**Electric Industries Ltd.**
**1-1, Koyakita 1-chome**
**Itami-shi Hyogo(JP)**
Inventor: **Yazu, Shuji Itami Works of Sumitomo**
**Electric Industries Ltd.**
**1-1, Koyakita 1-chome**
**Itami-shi Hyogo(JP)**

JAPANESE JOURNAL OF APPLIED PHYSICS, vol. 26, no. 9, September 1987, pages L1489-L1491, Tokyo, JP; T. AIDA et al.: "Preparation of YBa2Cu3O7-x superconducting thin films by RF-magnetron sputtering"

APPLIED PHYSICS LETTERS, vol. 51, no. 13, 28th September 1987, pages 1027-1029, American Institute of Physics, New York, US; M. GURVITCH et al.: "Preparation and substrate reactions of superconducting Y-Ba-Cu-O films"

Jap. Journ. of Appl. Phys., vol. 26, no. 8, August 1987, pp. L1320-1322.

Inventor: **Jodai, Tetsuji Itami Works of Sumitomo Electric Industries Ltd. 1-1, Koyakita 1-chome Itami-shi Hyogo(JP)**

(74) Representative: **Mongrédien, André c/o SOCIETE DE PROTECTION DES INVENTIONS 25, rue de Ponthieu F-75008 Paris (FR)**

## Description

Background of the Invention

Field of the invention

The present invention relates to a semiconductor substrate, more particularly, it relates to a semiconductor substrate having a superconducting thin film composed of a compound oxide and deposited on an oxide substrate and a semiconductor layer deposited on the superconductor thin layer.

The superconducting thin film layer of the semiconductor substrate according to the present invention can be used as a wiring material for semiconductor circuits which are built in the seminconductor layer and for fabricating Josephson junctions for Josephson devices.

The combination of the superconducting thin film and the semiconductor layer of the semiconductor substrate according to the present invention can be used for building superconducting devices such as superconducting transistors, a hot electron transistors or the like.

Description of the related art

One of the basic technologies for fabricating an integrated circuit on a semiconductor substrate of single crystal is metallization technology for forming patterned conductor lines which are used for interconnecting a variety of electronic elements which are fabricated by the other basic technology including an insulating layer forming stage, a patterning stage of the insulating layer and an impurity doping stage by means of thermal diffusion, ion implantation or the like. However, a part of the signal current passing through the metallic conductor lines is lost since the cross sectional area of the metallic wiring line become very fine in the case of integrated circuits built on a semiconductor. Therefore, it is demanded to deliver the signal current without current loss.

It is also demanded to increase the transmission velocity of signal current on the conducting lines in addition to increase the operating velocity of the active elements and passive elements themselves in order to improve the net operating velocity of the integrated circuits. However, the improvement in the transmission velocity of signal current through the conventional metallic conductor lines is limited because of the energy loss in the conducting lines. Still more, the increment in the integration degree lead to increment in power consumption owing to Joule heat which is generated in the metallic conducting lines, in other words, the degree of integration in the integrated circuit is limited. Thus, there have been strong demand to use superconductors as a material for the conductor lines.

The superconductivity is a phenomenon which is explained to be a kind of phase changes of electrons under which the electric resistance become zero and the perfect diamagnetism is observed. However, the critical temperature "Tc" of superconductivity could not exceed 23.2 K of $Nb_3Ge$ which was the the highest Tc for the past ten years, so that they have not used as a wiring material for ICs.

The possibility of an existence of a new type of superconducting material having much higher Tc was revealed by Bednorz and Müller, who discovered a new oxide type superconductor in 1986 [Z. Phys. B64 (1986)189].

It had been known that certain ceramic materials of compound oxides exhibit the property of superconductivity. For example, U. S. patent No. 3,932,315 discloses Ba-Pb-Bi type compound oxide which shows superconductivity and Japanese patent laid-open No. 60-173,885 discloses that Ba-Bi-Pb type compound oxides also show superconductivity. These superconductors, however, possess rather lower transition temperatures of about 10 K and hence usage of liquidized helium (boiling point of 4.2 K) as cryogen is indispensable to realize superconductivity.

The new type compound oxide superconductor discovered by Bednorz and Müller is represented by $[La, Sr]_2CuO_4$ which is called the $K_2NiF_4$-type oxide having a crystal structure which is similar to known perovskite type oxides. The $K_2NiF_4$-type compound oxides show such higher Tc as 30 K which are extremely higher than known superconducting materials.

It was also reported that C. W. Chu et al. discovered, in the United States of America, another superconducting material so called YBCO type represented by $YBa_2Cu_3O_{7-x}$ having the critical temperature of about 90 K in February 1987. Still other type new superconducting materials which were reported recently are a compound oxide of Bi-Sr-Ca-Cu-O system and Tl-Ba-Ca-Cu-O system which exhibit such high Tc as more than 100 K and which are chemically much stable than the abovementioned YBCO type compound oxide or the like.

And hence, the possibility of utilization of high-temperature superconductors as the wiring material for the integrated circuits.

The high-temperature superconductors are also demanded in the electronic devices. A typical application of the superconductor for the electronic devices is Josephson device in which quantum efficiency is observed macroscopically when an electric current is passed through a weak junction arranged between two superconductors. The tunnel junction type Josephson device is expected to be a high-speed and low-power consuming switching device owing to smaller energy gap of the superconducting material. It is also expected to utilize the Josephson device as a high sensitive sensor or detector for sensing very weak magnetic field, microwave, radiant ray or the like since variation of electromagnetic wave or magnetic field is reflected in variation of Josephson effect and can be observed as a precise quantum phenomenon. Development of the superconducting devices such as high-speed logic units or zero power loss wiring materials is also demanded in the field of high-speed computers in which the power consumption per unit area is reaching to the upper limit of the cooling capacity with increment of the integration density in order to reduce energy consumption.

Several ideas or concepts of new devices which is constructed by a combination of semiconductor and superconductor such as a superconducting transistor or a hot electron transistor have been proposed (M. Heiblum et al. "Solid State Electronics" Vol. 24, No. 343-346, 1981), but have not yet realized in a form of actual device.

In order to realize the above-mentioned superconducting devices such as the superconducting transistor or hot electron transistor, it is indispensable to prepare such a semiconductor substrate that has a semiconductor layer as well as a superconducting layer which are stratified or deposited homogeneously on a base.

The present applicant already proposed several processes for preparing the thin films of the high-Tc superconductor on a base substrate in the following patent applications: European patent applications EP-A-0 277 885, EP-A-0 284 489, EP-A-0 292 382, EP-A-0 292 387, EP-A-0 294 285 or the like.

An object of the present invention is to provide a novel semiconductor substrate having a superconducting layer composed of compound oxide and a semiconductor layer.

## Summary of the Invention

The present invention provides a semiconductor substrate comprising an oxide substrate, a thin film layer of oxide superconductor desposited on and covering whole surface of said oxide substrate, and a thin film layer of compound semiconductor deposited on and covering the whole surface of said thin film layer of oxide superconductor, a buffer layer being interposed between said thin film layer of compound semiconductor and said thin film layer of superconductor.

The superconducting thin film layer which can be used in the present invention may be any one of compound oxide type superconducting materials.

According to a preferred embodiment of the present invention, the superconducting thin film layer is composed mainly of a compound oxide of at least one element $\alpha$ selected from IIa group of the Periodic Table, at least one element $\beta$ selected from IIIa group of the Periodic Table and at least one element $\gamma$ selected from a group comprising Ib, IIb, IIIb, IVa and VIIIa groups of the Periodic Table.

Preferably, the superconductor is high-Tc copper containing superconductors.

One example of this type compound oxide is represented by the general formula:

$$(\alpha_{1-x}\beta_x)\gamma_yO_z$$

in which $\alpha$, $\beta$ and $\gamma$ have the same definition as above, x is an atomic ratio of $\beta$ with respect to $(\alpha + \beta)$ and has a range of $0.1 \leq x \leq 0.9$, and y and z are respective atomic ratios with respect to $(\alpha_{1-x}\beta_x)$ which is considered to be equal to 1 and each satisfies ranges of $0.4 \leq y \leq 3.0$ and $1 \leq z \leq 5$ respectively. The element $\alpha$ of IIa group element is preferably Ba, Sr, Ca. Mg, Be or the like. More preferably the element $\alpha$ is Ba and Sr from 10 % to 80 % of which may be replaced by one or two elements selected from a group comprising Mg and Ca. The element $\beta$ of IIIa group element is preferably lanthanide such as Y, La, Sc, Ce, Gd, Ho, Er, Tm, Yb or Lu. More preferably the element $\beta$ is Y, La or Ho from 10 % to 80 % of which may be replaced by Sc or one or two elements selected from a group comprising the other lnathanide elements.

The $\gamma$ is copper a part of which can be replaced by the other element selected from a group comprising Ib, IIb, IIIb, IVa and VIIIa groups of the Periodic Table such as Ti or V. Particularly, the superconducting thin film of this type compound oxide is preferably a compound oxide preferably represented by the general formula:

$(La_{1-x}\alpha_x)_2CuO_4$

in which $\alpha$ stands for Ba or Sr. These compound oxides are considered to be composed mainly of perovskite type or oxygen deficient perovskite type crystalline structure. Another example of the above-mentioned compound oxide is a so called YBCO type compound oxide represented by the general formula:

$Ln_1Ba_2Cu_3O_{7-\delta}$

in which Ln stands for at least one lanthanide element selected from a group comprising La, Nd, Sm, Eu, Gd, Dy, Ho, Y, Er, Yb, Tm and Lu and $\delta$ is a number which satisfies a range of $0 \leq \delta < 1$. Namely this type compound oxide are following systems:

| | | |
|---|---|---|
| $Y_1Ba_2Cu_3O_{7-\delta},$ | $Ho_1Ba_2Cu_3O_{7-\delta},$ | $Lu_1Ba_2Cu_3O_{7-\delta},$ |
| $Sm_1Ba_2Cu_3O_{7-\delta},$ | $Nd_1Ba_2Cu_3O_{7-\delta},$ | $Gd_1Ba_2Cu_3O_{7-\delta},$ |
| $Eu_1Ba_2Cu_3O_{7-\delta},$ | $Er_1Ba_2Cu_3O_{7-\delta},$ | $Dy_1Ba_2Cu_3O_{7-\delta},$ |
| $Tm_1Ba_2Cu_3O_{7-\delta},$ | $Yb_1Ba_2Cu_3O_{7-\delta},$ | $La_1Ba_2Cu_3O_{7-\delta}$ |

in which $\delta$ is a number which satisfies a range of $0 < \delta < 1$ and possess preferably perovskite type or quasi-perovskite type crystal structure. The term quasi-perovskite type means a structure which can be considered to have such a crystal structure that is similar to perovskite-type oxides and includes an orthorhombically distorted perovskite or a distorted oxygen-deficient perovskite or the like.

An atomic ratio of the lanthanide element "Ln":Ba:Cu is preferably 1 : 2: 3 as is defined by the formula but the atomic ratio is not restricted strictly to this ratio. In fact, the other compound oxides having different atomic ratios which are deviate from the above-mentioned value by 10 % may exhibit superconducting property.

The above-compound oxide contains further at least one element selected from the group comprising Al, Fe, Co, Ni, Zn, Ag and Ti.

Still another example of the above-mentioned compound oxide is compound oxides represented by the general formula:

$\Theta_4(\Phi_{1-q},Ca_q)_mCu_nO_{p+r}$

in which $\Theta$ stands for Bi or Tl, $\Phi$ stands for Sr when $\Theta$ is Bi and stands for Ba when $\Theta$ is Tl, m and n are numbers each satisfying ranges of $6 \leq m \leq 10$ and $4 \leq n \leq 8$ respectively, $p = (6+m+n)$, q is a number which satisfies a range of $0 < q < 1$, and r is a number which satisfies a range of $-2 \leq r \leq +2$. Namely, this type compound oxide include the following systems:

| | |
|---|---|
| $Bi_4Sr_4Ca_4Cu_6O_{20-r},$ | $Bi_2Sr_2Ca_2Cu_3O_{10-r},$ |
| $Tl_4Ba_4Ca_4Cu_6O_{20-r},$ | $Tl_2Ba_2Ca_2Cu_3O_{10-r}$ |

in which r is a number which satisfies a range of $-2 \leq r \leq +2$.

The oxide substrate which can be used in the present invention is preferably a single crystal of MgO, $SrTiO_3$, $Al_2O_3$, $LiNbO_3$, $LiTaO_3$ or $ZrO_2$ in order to assure orientation of crystalline structure of the superconducting thin film deposited on the substrate.

In fact, the superconducting thin films of the above-mentioned type compound oxides shows anisotropy in the critical current density. Namely, the current passing along a direction which is in parallel with a plane defined by a-axis and b-axis of the crystal show a very high critical current density, while the current passing along the other directions is relatively lower. Therefore, in order to match the crystalline orientation of the superconducting thin film with that of the substrate, it is preferable to deposit the superconducting thin film on the specified plane of a single crystal such as MgO, $SrTiO_3$, YSZ, $ZrO_2$ or the like whose lattice distance is nearly same as the lattice distance of the compound oxide crystal. It is preferable to deposit the superconducting thin film on {001} plane of a single crystal of MgO or $SrTiO_3$. It is also possible to use {110} plane. In this case, the c-axis become in parallel with a surface of a substrate, so that current is flown perpendicularly with respect to the c-axis in the practical uses. Still more, since the thermal expansion coefficient of MgO or $SrTiO_3$ is similar to that of the superconductor of compound oxide, the thin film is not subjected to undesirable stress caused by difference in the thermal expansion coefficient which will be exerted during the heating and cooling stages.

According to the present invention, the semiconductor layer is composed of compound semiconductor material. The compound semiconductor material is preferably selected from a group comprising GaAs, InP, InSb, ZnSe, CdTe, SiC, GaP, HgCdTe, GaAlAs, GaInAs, InAlAs and InGaAsP.

Now, we will describe a process for producing the above-mentioned semiconductor substrate according to the present invention.

At first, the superconducting thin film layer is deposited on the oxide substrate by physical vapour deposition (PVD) technique such as sputtering, vacuum-deposition, molecular beam epitaxy (MBE), ion beam deposition or the like or by chemical vapour deposition (CVD) technique such as thermal CVD, plasma CVD, photo CVD, MOCVD or the like. Among the physical vapour deposition (PVD) technique, magnetron sputtering is most preferable. The deposited thin film is preferably further heat-treated in oxygen-containing atmosphere or exposed to oxygen plasma in order to adjust the oxygen contents to a proper concentration in the crystalline structure of which the superconducting thin film is composed.

Then, the semiconductor layer is deposited on the resulting superconducting thin film layer. The deposition of the semiconductor layer can be effected by a known technique. According to a preferred embodiment of the present invention, the compound semiconductor layer is deposited by the conventional chemical vapour deposition (CVD) technique on the superconducting thin film layer. As the other deposition technique of the semiconductor layer, it can be mentioned the conventional physical process such as vacuum deposition, sputtering, ion milling, molecular beam epitaxy or the like. In either case, the deposition of the semiconductor layer should be operated carefully in order not to spoil the superconducting properties of the superconducting thin film layer on which the semiconductor layer is deposited by watching the deposition atmosphere and the substrate temperature.

According to the invention, a buffer layer is interposed between the superconducting thin film layer and the compound semiconductor layer. The buffer layer is deposited on the superconducting thin film layer before the deposition of the compound semiconductor layer. The function of this buffer layer is to prevent the constituent elements of the compound semiconductor layer from diffusing into the superconducting thin film layer and to facilitate formation or crystallization of the semiconductor layer. In this sense, the buffer layer possesses preferably the same lattice constant as a single crystal of the semiconductor layer. The buffer layer is preferably made of platinum (Pt).

When electronic systems or semiconductor devices are fabricated in the semiconductor substrate according to the present invention, the superconducting thin film layer can be removed locally by etching technique or the like so that the superconducting thin film layer is shaped into a desired pattern before the semiconductor layer is deposited. It is also possible to effect the conventional minute processing for example by lithography directly on the semiconducting substrate according to the present invention.

The superconducting thin film layer of the semiconductor substrate according to the present invention can be used as a wiring material for semiconductor circuits which are built in the semiconductor layer.

The semiconductor substrate according to the present invention can be used also as a substrate for fabricating an integrated circuit for building novel superconducting elements or as a substrate on which electronic devices are built. For example, Josephson junctions can be fabricated in the superconducting thin film to built Josephson devices. The semiconductor substrate according to the present invention can be used also for fabricating high-speed semiconductor devices such as superconducting transistors having more than three electrodes, superconducting FETs or hot electron transistors which utilized the interface between the superconducting thin film layer and the semiconductor layer.

In conclusion, the superconducting substrate is expected to accelerate technology for improving the operating velocity of semiconductor devices and for increasing the degree of integration.

The following examples do not include the buffer layer and serve as technical background only.

Example 1

Two semiconductor substrate samples according to the present invention are prepared by depositing a semiconductor layer of GaAs on two superconducting thin film layers of Y-Ba-Cu-O system and Ho-Ba-Cu-O system.

At first, the superconducting thin films are deposited on a {100} plane of a single crystal of MgO and on a {100} plane of a single crystal of $SrTiO_3$ respectively by magnetron RF sputtering technique which is itself known. Targets used in the sputtering are sintered powder of $YBa_2Cu_{4.5}O_x$ for Y-Ba-Cu-O system and $HoBa_{2.3}Cu_{4.7}O_x$ for Ho-Ba-Cu-O system respectively. Special attention is paid to the distance between the substrate and the target and to the power of high-frequency, while the substrate is heated at 700 °C during the sputtering operation so that superconducting thin film layers of the respective compound oxides are grown to 100 nm (1,000 Å).

After the deposition of the thin films of compound oxides complete, the deposited thin films are heated at 850 °C in oxygen gas atmosphere of 1 atm and are left at this temperature for one hour. Then, the substrates having the deposited thin films are cooled slowly to 400 °C at a cooling rate of 3 °C/min and then are cooled from 400 °C to ambient temperature at a cooling rate of 10 °C/min.

Then, a semiconductor layer of GaAs having a thickness of 200 nm (2,000 Å) is deposited on the resulting respective superconducting thin film layers by the MOCVD method under the following conditions:

| | |
|---|---|
| Source gases: | TMG and $AsH_3$ |
| Substrate temperature: | 650 °C |
| Deposition rate: | 30 nm/min (300 Å/min) |

The resulting respective semiconductor substrate having the semiconductor layer deposited on the respective superconducting thin film layer show good condition at an interface between the semiconductor layer and the superconducting thin film layer. Table 1 shows the critical temperature Tco (a temperature where the phenomenon of superconductivity start to be observed) and Tci (a temperature where zero resistance is observed) of the superconducting thin films on the respective samples.

Table 1

| Substrate | Superconducting thin film | Critical temperature (K) | |
|---|---|---|---|
| | | Tco | Tci |
| MgO | Y-Ba-Cu system | 96 | 94 |
| | Ho-Ba-Cu system | 98 | 95 |
| $SrTiO_3$ | Y-Ba-Cu system | 97 | 94 |
| | Ho-Ba-Cu system | 93 | 90 |

Example 2

The same operation as Example 1 is repeated except that the semiconductor layer of GaAs is replaced by InP, InSb, ZnSe, CdTe, SiC, GaP, HgCdTe, GaAlAs, GaInAs, InAlAs and InGaAsP respectively to prepare each two semiconductor substrate samples according to the present invention.

Each semiconductor layer of these compound semiconductor materials is deposited until a thickness of 200 nm (2,000 Å) on the respective superconducting thin film layers by the MOCVD method by using organometals as source gases under the same condition as Example 1.

The resulting semiconductor substrates having respective semiconductor layers deposited on the respective superconducting thin film layers show good conditions at the interface between the semiconductor layer and the superconducting thin film layer. Table 2 shows the critical temperature Tco and Tci of the superconducting thin films on the respective samples.

Table 2 (to be continued)

| Substrate | Superconducting thin film | Semiconductor layer | Critical temperature Tco (K)   Tci (K) | |
|---|---|---|---|---|
| MgO | Y-Ba-Cu system | InP | 98 | 96 |
| | | InSb | 95 | 93 |
| | | ZnSe | 98 | 95 |
| | | CdTe | 98 | 95 |
| | | SiC | 96 | 93 |
| | | GaP | 94 | 91 |
| | | HgCdTe | 95 | 92 |
| | | GaAlAs | 97 | 95 |
| | | GaInAs | 97 | 95 |
| | | InAlAs | 96 | 93 |
| | | InGaAsP | 95 | 92 |
| | Ho-Ba-Cu system | InP | 97 | 94 |
| | | InSb | 96 | 94 |
| | | ZnSe | 95 | 93 |
| | | CdTe | 95 | 93 |
| | | SiC | 95 | 93 |
| | | GaP | 96 | 94 |
| | | HgCdTe | 96 | 93 |
| | | GaAlAs | 96 | 93 |
| | | GaInAs | 96 | 94 |
| | | InAlAs | 98 | 96 |
| | | InGaAsP | 98 | 96 |

## Table 2 ( continued)

| Substrate | Superconducting thin film | Semiconductor layer | Critical temperature Tco (K)   Tci (K) | |
|---|---|---|---|---|
| SrTiO$_3$ | Y-Ba-Cu system | InP | 96 | 94 |
| | | InSb | 97 | 92 |
| | | ZnSe | 97 | 93 |
| | | CdTe | 97 | 93 |
| | | SiC | 98 | 96 |
| | | GaP | 98 | 94 |
| | | HgCdTe | 98 | 96 |
| | | GaAlAs | 93 | 91 |
| | | GaInAs | 97 | 94 |
| | | InAlAs | 98 | 95 |
| | | InGaAsP | 96 | 94 |
| | Ho-Ba-Cu system | InP | 95 | 92 |
| | | InSb | 94 | 92 |
| | | ZnSe | 97 | 95 |
| | | CdTe | 97 | 95 |
| | | SiC | 94 | 91 |
| | | GaP | 95 | 93 |
| | | HgCdTe | 94 | 91 |
| | | GaAlAs | 91 | 89 |
| | | GaInAs | 94 | 92 |
| | | InAlAs | 94 | 92 |
| | | InGaAsP | 94 | 91 |

Example 3

The same operation as Example 1 is repeated except that a superconducting thin film of Bi-Sr-Ca-Cu-O system is deposited on a {100} plane of a single crystal of MgO in place of Y-Ba-Cu-O system and Ho-Ba-Cu-O system used in Example 1 by using a target of $Bi_{1.4}Sr_1Ca_1Cu_{1.5}O_x$

The resulting semiconductor substrate having a semiconductor layer of GaAs deposited on the superconducting thin film layer of Bi-Sr-Ca-Cu-O system shows good condition at the interface between the semiconductor layer and the superconducting thin film layer. Table 3 shows the critical temperature Tco and Tci of the superconducting thin film.

Table 3

| Substrate | Superconducting thin film | Critical temperature (K) | |
|---|---|---|---|
| | | Tco | Tci |
| MgO | Bi-Sr-Ca-Cu system | 117 | 102 |

## Claims

1. A semiconductor substrate comprising an oxide substrate, a thin film layer of oxide superconductor deposited on and covering the whole surface of said oxide substrate, and a thin film layer of compound semiconductor deposited on and covering the whole surface of said thin film layer of oxide superconductor, a buffer layer being interposed between said thin film layer of compound semiconductor and said thin film layer of superconductor.

2. The substrate set forth in claim 1 wherein said compound semiconductor is selected from the group consisting of GaAs, InP, InSb, ZnSe, CdTe, SiC, GaP, HgCdTe, GaAlAs, GaInAs, InAlAs and InGaAsP.

3. The substrate set forth in claim 1 wherein the lattice parameters of said buffer layer are similar to those of said thin film layer of semiconductor.

4. The substrate set forth in claim 1 wherein said buffer layer is made of platinum.

5. The substrate set forth in any one of claim 1 to 4 wherein said superconductor is high-Tc copper-containing superconductors.

6. The substrate set forth in claim 5 wherein said superconductor is a compound oxide represented by the general formula:

$$(\alpha_{1-x}\beta_x)Cu_yO_z$$

in which $\alpha$ is at least one element selected from IIa group and $\beta$ is at least one element selected from IIIa group, "x" is an atomic ratio of $\beta$ with respect to $(\alpha + \beta)$ and has a range of $0.1 \leqq x \leqq 0.9$, and y and z are respective atomic ratios with respect to $(\alpha_{1-x}\beta_x)$ which is considered to be equal to 1 and each satisfies $0.4 \leqq y \leqq 3.0$ and $1 \leqq z \leqq 5$.

7. The substrate set forth in claim 6 wherein said superconductor is a compound oxide represented by the general formula:

$$(La_{1-x}\alpha_x)_2 Cu O_4$$

in which $\alpha$ stands for Ba or Sr.

8. The substrate set forth in claim 5 wherein said superconductor have a crystal structure of perovskite or oxygen deficient perovskite.

9. The substrate set forth in claim 5 wherein said superconductor is a compound oxide represented by the general formula:

$$Ln_1 Ba_2 Cu_3 O_{7-\delta}$$

in which "Ln" stands for at least one lanthanide element selected from a group comprising La, Nd, Sm, Eu, Gd, Dy, Ho, Y, Er, Yb, Tm and Lu and $\delta$ is a number satisfying a range of $0 \leqq \delta < 1$.

10. The substrate set forth in claim 9 wherein "Ln" is Y, Er, Ho or Dy.

11. The substrate set forth in claim 9 wherein said compound oxide contain further at least one element selected from the group comprising Al, Fe, Co, Ni, Zn, Ag and Ti.

12. The substrate set forth in claim 5 wherein said superconductor is a compound oxide represented by the general formula:

$$\Theta_4(\Phi_{1-q}, Ca_q)_m Cu_n O_{p+r}$$

in which $\Theta$ stands for Bi or Tl. $\Phi$ stands for Sr when $\Theta$ is Bi and stands for Ba when $\Theta$ is Tl, "m" and "n" are numbers each satisfying $6 \leq m \leq 10$ and $4 \leq n \leq 8$ respectively, $p = (6 + m + n)$, "q" is a number satisfying a range of $0 < q < 1$, and "r" is a number satisfying a range of $-2 \leq r \leq +2$.

13. The substrate set forth in claim 1 wherein said oxide substrate is made of a single crystal of MgO, $SrTiO_3$, $Al_2O_3$, $LiNbO_3$, $LiTaO_3$ or $ZrO_2$.

## Patentansprüche

1. Halbleitersubstrat mit einem Oxidsubstrat, einer Dünnfilmschicht aus einem Oxidsupraleiter, der auf der gesamten Oberfläche des Oxidsubstrats vorgesehen ist und diese bedeckt, und einer Dünnfilmschicht eines Mischhalbleiters (Compound-Halbleiters), der auf der gesamten Oberfläche der Dünnfilmschicht des Oxidsupraleiters vorgesehen ist und diese bedeckt, wobei eine Pufferschicht zwischen der Dünnfilmschicht des Mischhalbleiters und der Dünnfilmschicht des Supraleiters vorgesehen ist.

2. Substrat nach Anspruch 1, bei der der Mischhalbleiter aus der durch GaAs, InP, InSb, ZnSe, CdTe, SiC, GaP, HgCdTe, GaAlAs, GaInAs, InAlAs and InGaAsP gebildeten Gruppe ausgewählt ist.

3. Substrat nach Anspruch 1, wobei die Gitterparameter der Pufferschicht denen der Dünnfilmschicht des Halbleiters ähnlich sind.

4. Substrat nach Anspruch 1, bei dem die Pufferschicht aus Platin hergestellt ist.

5. Substrat nach einem der Ansprüche 1 bis 4, bei dem der Supraleiter ein Hoch-Tc-Supraleiter mit Kupfergehalt ist.

6. Substrat nach Anspruch 5, bei dem der Supraleiter ein Mischoxid der allgemeinen Formel ist:

$$(\alpha_{1-x}\beta_x)Cu_y O_z$$

worin $\alpha$ mindestens ein Element aus der Gruppe IIa ist und $\beta$ mindestens ein Element aus der Gruppe IIIa ist, x ein Atomverhältnis von $\beta$ in Bezug auf $(\alpha + \beta)$ ist und einem Bereich von $0,1 \leq x \leq 0,9$ entspricht und y und z jeweilige Atomverhältnisse im Bezug auf $(\alpha_{1-x}\beta_x)$ sind, was annahmegemäß gleich 1 ist und die jeweils $0,4 \leq y \leq 3,0$ bzw. $1 \leq z \leq 5$ entsprechen.

7. Substrat nach Anspruch 6, bei dem der Supraleiter ein Mischoxid der allgemeinen Formel ist:

$$(La_{1-x}\alpha_x)_2 CuO_4$$

worin $\alpha$ Ba oder Sr bedeutet.

8. Substrat nach Anspruch 5, bei dem der Supraleiter eine Kristallstruktur von Perovskit oder Perovskit mit Sauerstoffmangel besitzt.

9. Substrat nach Anspruch 5, bei dem der Supraleiter ein Mischoxid der allgemeinen Formel ist:

$$Ln_1 Ba_2 Cu_3 O_{7-\delta}$$

worin Ln mindestens ein Lanthaniden-Element bedeutet, das aus der durch La, Nd, Sm, Eu, Gd, Dy, Ho, Y, Er, Yb, Tm und Lu gebildeten Gruppe ausgewählt ist, und $\delta$ eine Zahl ist, die dem Bereich $0 \leq \delta$

EP 0 323 342 B1

≦ 1 entspricht.

10. Substrat nach Anspruch 9, worin Ln Y, Er, Ho oder Dy ist.

11. Substrat nach Anspruch 9, worin das Mischoxid zusätzlich mindestens ein Element aus der durch Al, Fe, Co, Ni, Zn, Ag und Ti gebildeten Gruppe enthält.

12. Substrat nach Anspruch 5, worin der Supraleiter ein Mischoxid der allgemeinen Formel ist:

$$\Theta_4 (\Phi_{1-q}Ca_q)_m Cu_n O_{p+r}$$

worin $\Theta$ Bi oder Tl bedeutet; $\Phi$ Sr bedeutet, wenn $\Theta$ Bi bedeutet, und Ba bedeutet, wenn $\Theta$ Tl ist, m und n Zahlen sind, die $6 \leq m \leq 10$ bzw. $4 \leq n \leq 8$ entsprechen, $p = (6+m+n)$, q eine Zahl ist, die dem Bereich von $0 < q < 1$ entspricht und r eine Zahl ist, die dem Bereich von $-2 \leq r \leq +2$ entspricht.

13. Substrat nach Anspruch 1, wobei das Oxidsubstrat aus einem Einkristall von MgO, $SrTiO_3$, $Al_2O_3$, $LiNbO_3$, $LiTaO_3$ oder $ZrO_2$ hergestellt ist.

**Revendications**

1. Substrat semi-conducteur comprenant un substrat d'oxyde, une mince couche en pellicule d'oxyde supraconducteur déposée sur et recouvrant toute la surface dudit substrat oxyde, et une mince couche en pellicule de composé semi-conducteur déposée sur et recouvrant toute la surface de ladite mince couche en pellicule d'oxyde supraconducteur, une couche tampon étant interposée entre ladite mince couche en pellicule de composé semi-conducteur et ladite mince couche en pellicule de supraconducteur.

2. Substrat selon la revendication 1 dans lequel ledit composé semi-conducteur est choisi dans le groupe constitué par GaAs, InP, InSb, ZnSe, CdTe, SiC, GaP, HgCdTe, GaAlAs, GaInAs, InAlAs, et InGaAsP.

3. Substrat selon la revendication 1 dans lequel les paramètres du réseau de ladite couche tampon sont semblables à ceux de ladite mince couche en pellicule de semiconducteur .

4. Substrat selon la revendication 1 dans lequel ladite couche tampon est faite de platine.

5. Substrat selon une quel conque des revendications 1 à 4 dans lequel ledit supraconducteur est un supraconducteur contenant du cuivre à haute teneur en Tc.

6. Substrat selon la revendication 5 dans lequel ledit supraconducteur est un composé d'oxyde repésenté par la formule générale :

$$(\alpha_{1-x}\beta_x)Cu_yO_z$$

dans laquelle $\alpha$ est au moins un élément choisi dans le groupe IIa et $\beta$ est au moins un élément choisi dans le groupe IIIa, "x" est le rapport atomique de $\beta$ à $(\alpha+\beta)$ et a un intervalle de $0,1 \leq x \leq 0,9$ , et y et z sont les rapports atomiques respectifs relativement à $(\alpha_{1-x}\beta_x)$ qui est considéré comme étant égal à 1 , chacun satisfaisant à $0,4 \leq y \leq 3,0$ et $1 \leq z \leq 5$ .

7. Substrat selon la revendication 6 dans lequel ledit supraconducteur est un composé d'oxyde représenté par la formule générale :

$$(La_{1-x}\alpha_x)_2 CuO_4$$

dans laquelle $\alpha$ représente Ba ou Sr.

8. Substrat selon la revendication 5 dans lequel ledit supraconducteur a une structure cristalline de pérovskite ou de pérovskite déficient en oxygène.

12

**9.** Substrat selon la revendication 5 dans lequel ledit supraconducteur est un composé oxyde représenté par la formule générale:

$$Ln_1 Ba_2 CU_3 O_{7-\delta}$$

dans laquelle "Ln" représente au moins un élément lanthanide choisi dans le groupe comprenant La, Nd, Sm, Eu, Gd, Dy, Ho, Y, Er, Yb, Tm et Lu et $\delta$ est un nombre satisfaisant à l'intervalle $0 \leqq \delta < 1$ .

**10.** Substrat selon la revendication 9 dans lequel "Ln" représente Y, Er, Ho ou Dy.

**11.** Substrat selon la revendication 9 dans lequel ledit composé oxyde contient en outre au moins un élément choisi dans le groupe comprenant Al, Fe, Co, Ni, Zn, Ag, et Ti.

**12.** Substrat selon la revendication 5 dans lequel ledit supraconducteur est un composé d'oxyde représenté par la formule générale:

$$\Theta_4 (\Phi_{1-q,} Ca_q)_m Cu_n O_{p+r}$$

dans laquelle $\Theta$ représente Bi ou Tl, $\Phi$ représente Sr lorsque $\Theta$ représente Bi et représente Ba lorsque représente $\Theta$ représente Tl, "m" et "n" sont des nombres satisfaisants chacun à $6 \leqq m \leqq 10$ et $4 \leqq n \leqq 8$ respectivement, $p = (6 + m + n)$, "q" est un nombre satisfaisant à l'intervalle $0 < q < 1$ , et "r" est un nombre satisfaisant à l'intervalle $-2 \leqq r \leqq +2$ .

**13.** Substrat selon la revendication 1 dans lequel ledit substrat oxyde est fait d'un seul cristal de MgO, $SrTiO_3$, $Al_2 O_3$, $LiNbO_3$, $LiTaO_3$ ou $ZrO_2$ .